## Europäisches Patentamt

(19) **European Patent Office**

**Office européen des brevets**

(11) Veröffentlichungsnummer: **0 054 703**
**B1**

(12) # EUROPÄISCHE PATENTSCHRIFT

(45) Veröffentlichungstag der Patentschrift:
23.01.85

(51) Int. Cl.⁴: **B 06 B 1/06**

(21) Anmeldenummer: 81109041.4

(22) Anmeldetag: 27.10.81

(54) Schaltungsanordnung für piezoelektrisches Stellglied und dergleichen.

(30) Priorität: 23.12.80 DE 3048632

(43) Veröffentlichungstag der Anmeldung:
30.06.82 Patentblatt 82/26

(45) Bekanntmachung des Hinweises auf die Patenterteilung:
23.01.85 Patentblatt 85/4

(84) Benannte Vertragsstaaten:
AT BE CH DE FR GB IT LI NL SE

(56) Entgegenhaltungen:
DE - A - 2 551 603
FR - A - 2 127 657
US - A - 3 916 373

(73) Patentinhaber: Siemens Aktiengesellschaft, Berlin und
München Wittelsbacherplatz 2, D-8000 München 2 (DE)

(72) Erfinder: Mágori, Valentin, Dipl.-Phys.,
Limburgstrasse 17, D-8000 München 90 (DE)
Erfinder: Kleinschmidt, Peter, Dipl.-Phys., Klagenfurter
Strasse 12, D-8000 München 90 (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Beschreibung

Die vorliegende Erfindung bezieht sich auf eine Schaltung für ein piezoelektrisches Stellglied oder dergleichen, wie sie im Oberbegriff des Patentanspruchs 1 angegeben ist.

Bei piezoelektrischen Stellgliedern, wie sie z. B. aus der DE-A-3 040 563 bekannt sind, handelt es sich um piezoelektrische Bauelemente, deren elektrisch bewirkte Elongation oder Kontraktion für mechanische Arbeitsleistung verwendet wird. Solche Stellglieder haben einen in der Regel länglichen piezoelektrischen Körper, der z. B. ein Stapel aufeinanderliegender Scheiben ist oder aus aneinander befestigten länglichen Streifen besteht, wobei die Scheiben oder die Streifen aus piezokeramischem Material, wie z. B. Bleizirkonat-Titanat, Bariumtitanat und dergleichen, sind.

Ein solches Stellglied ist für eine anzulegende elektrische Spannung eine elektrische Kapazität, die aufzuladen ist. Während des Ablaufs dieses Aufladevorgangs führt der betreffende piezokeramische Körper eine Dilatation oder Kontraktion aus, und zwar abhängig vom Vorzeichen des piezoelektrischen Effekts bzw. des elektromechanischen Kopplungsfaktors, der im betreffenden Fall zur Wirkung kommt. In entsprechender Weise kann auch der Kontraktions- oder Dilatationseffekt ausgenutzt werden, der auftritt, wenn ein zuvor elektrisch aufgeladener piezokeramischer Körper kurzgeschlossen wird und seine elektrische Kapazität entladen wird.

Obwohl die Längenänderungen eines piezokeramischen Körpers beim Anlegen von elektrischer Spannung relativ gering sind, etwa vergleichsweise zu Bewegungen eines Stößels, der von einem Nocken angetrieben wird, ist ein piezokeramisches Stellglied in der Lage, erheblich hohe Kräfte auszuüben und entsprechende Arbeitsleistung zu erbringen. Es muß hierzu aber nicht nur diese Arbeitsleistung in elektrischer Energie aufgewandt werden, sondern es kommt noch der Blindenergie-Anteil der Aufladung der elektrischen Kapazität hinzu, der ein Vielfaches der abgegebenen mechanischen Leistung ist. Der Vollständigkeit halber sei noch darauf hingewiesen, daß für den Betrieb eines wie angegebenen piezoelektrischen Stellglieds Hochspannung in der Größenordnung von 1000 bis mehreren 1000 Volt notwendig ist, die entsprechend dem gewünschten Stellvorgang gesteuert werden muß und für deren Erzeugung und Steuerung eine entsprechende elektronische Schaltung bereitzustellen ist. Insbesondere spielt der Gesamtenergie-Bedarf für den Stellvorgang dann eine Rolle, wenn das Stellglied aus einer Batterie betrieben werden soll oder nur Niedervolt-Gleichspannung von beispielsweise 12 Volt zur Verfügung steht.

Es ist eine Aufgabe der vorliegenden Erfindung, eine elektronische Schaltung anzugeben, mit der ein energiesparender Betrieb eines wie angegebenen Stellglieds mit piezokeramischem Wandler möglich ist.

Diese Aufgabe wird mit einer Schaltung nach dem Oberbegriff des Patentanspruchs 1 erfindungsgemäß mit den Merkmalen des Kennzeichens des Patentanspruchs 1 gelöst. Weitere Ausgestaltungen und Weiterbildungen der Erfindung gehen aus den Unteransprüchen hervor.

Die Erfindung ist insbesondere für solche piezoelektrische Körper von Bedeutung, deren piezoelektrische Wirkung vom Kopplungsfaktor $k_{31}$ bzw. von der piezoelektrischen Konstante $d_{31}$ abhängt. Dies sind die bereits oben erwähnten, aus parallel nebeneinander angeordneten länglichen Streifen bzw. Folienstreifen gebildeten piezoelektrischen Körper. Derartige piezoelektrische Körper haben an sich einen ungünstigeren Umsetzungsgrad, d. h. ein ungünstiges Verhältnis zwischen der an den Anschlüssen des piezoelektrischen Körpers in diesen hereinfließenden elektrischen (Wirk- und Blind-)Energie und der umgesetzten Leistung, d. h. es tritt bei diesen ein besonders hoher Anteil an elektrischer Blindleistung auf, die beim Kurzschließen des piezoelektrischen Körpers für den Übergang in den Ausgangszustand vernichtet werden würde.

Der Erfindung liegt das Prinzip zugrunde, die bei Entladung des (zuvor aufgeladenen) piezoelektrischen Körpers auftretende Blindenergie in einem elektrischen Kondensator mit der Kapazität C zu speichern, um bei Wiederaufladen des piezoelektrischen Körpers diese im Kondensator gespeicherte Energie in den piezoelektrischen Körper wieder zurückfließen zu lassen. Das Maß der möglichen Speicherung hängt aber vom Kapazitätsverhältnis von piezoelektrischem Körper und elektrischem Speicherkondensator ab, so daß bei beispielsweise gleich großen Kapazitätswerten nur jeweils 50% gespeichert werden kann und 50% der Energie im Körper zurückbleibt. Gleiches gilt für den umgekehrten Prozeß des Zurückfließens. Anders ist dies jedoch, wenn erfindungsgemäß eine Induktivität L in Reihe mit diesen beiden Kapazitäten von Stellglied und Kondensator geschaltet wird und im Nulldurchgang des Umladestromes der Umladestromkreis unterbrochen wird, wobei die Induktivität einen solchen Wert hat, daß sie in der Lage ist, die gesamte elektrische Energie aus dem Stellglied (bzw. bei der Rückumladung die des Kondensators) magnetisch zwischenzuspeichern. Dies bedeutet für die Induktivität, daß sie bei der Frequenz

$$f = \frac{1}{2\pi\sqrt{L\bar{C}}}$$

und bei der sich ergebenden Strombelastung noch eine Güte $Q \geq 3$ aufweisen soll, worin $\bar{C}$ der Kapazitätswert der Reihenschaltung aus piezoelektrischem Körper und zusätzlichem Kondensator ist. Die Umladezeit $t_u$ sollte mindestens in der Größenordnung des halben Reziprokwertes der mechanischen Betriebs-Resonanzfrequenzen f des in eine Vorrichtung eingebauten Stellglieds liegen

$$\left(t_u \approx \frac{1}{2f}\right)$$

oder größer sein.

Im Idealfall läßt sich damit 100% der Blindenergie des zuvor aufgeladenen piezokeramischen Elements auf einen gleich groß bemessenen Kondensator umladen und umgekehrt von dem Kondensator diese Energie wieder zurückspeisen. Aus einem anzuschließenden Generator ist in diesem Idealfall dann nur noch die als mechanische Arbeit verbrauchte elektrische Leistung nachzuliefern. Zur Erfindung gehört die Maßnahme, für wenigstens eine der Kapazitäten (Stellglied und/oder zusätzlicher Kondensator) zu verhindern, daß sich bei wiederholtem Umladen Restladungen in dieser Kapazität kumulieren.

Die Erfindung ist besonders dort mit Vorteil anzuwenden, wo nicht nur ein einziger piezoelektrischer Körper, sondern im Gegentakt zwei piezoelektrische Körper für den Betrieb als Stellglied aufzuladen und zu entladen sind und der eine piezoelektrische Körper hinsichtlich der Blindenergie als Energiespeicher des anderen piezoelektrischen Körpers und umgekehrt wirkt. Solche Funktion liegt z. B. bei einem Tandem-Stellglied nach der zeitgleichen Europäischen Patentanmeldung 0 054 704-A3, vor. Die Erfindung kann im übrigen auch bei mehr als zwei piezoelektrischen Körpern angewendet werden, die sich auf zwei im Gegentakt arbeitende Gruppen solcher piezoelektrischer Körper aufteilen lassen. Ein eventuell verbleibendes Rest-Ungleichgewicht der Kapazitäten der piezoelektrischen Körper der beiden Gruppen kann mit Hilfe eines dann wesentlich kleineren Zusatzkondensators auf gleich große Kapazitätswerte der Gruppen zueinander ausgeglichen werden.

Weitere Einzelheiten der Erfindung gehen aus der nachfolgenden, anhand der Figuren gegebenen Beschreibung von Ausführungsbeispielen hervor.

Fig. 1 zeigt eine prinzipielle Schaltungsanordnung der Erfindung.

Fig. 2 zeigt ein Betriebsdiagramm zu Fig. 1.

Fig. 3 und 4 zeigen Weiterbildungen der Erfindung.

Fig. 5 zeigt eine schaltungsmäßige Realisierung.

Fig. 6 und 7, 7a zeigen bevorzugte Anwendungsfälle.

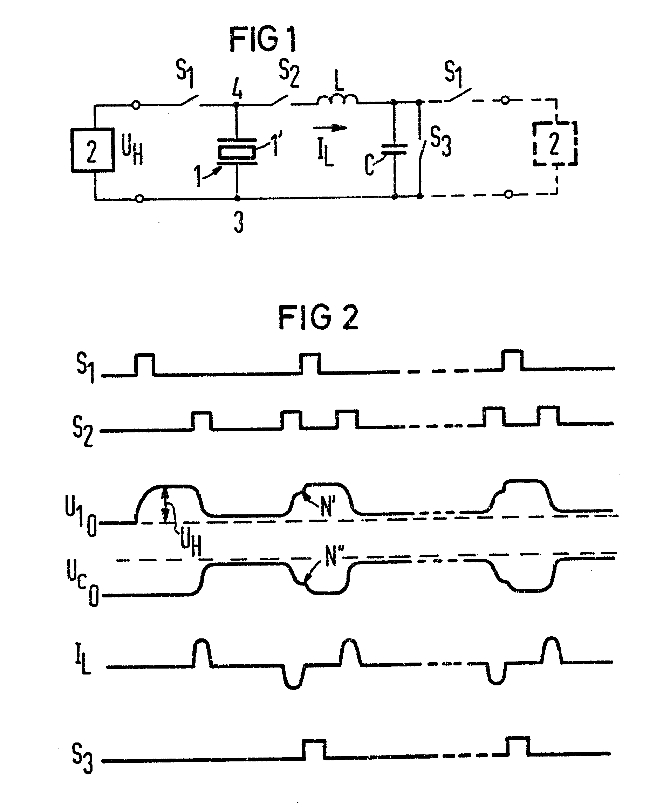

Das Schaltbild der Fig. 1 läßt bereits die prinzipielle Funktion der Erfindung bzw. den ihr zugrundeliegenden Gedanken erkennen. Zur Betätigung des mit 1 insgesamt gekennzeichneten Stellglieds in den zweiten Stellzustand, d. h. zur elektrischen Aufladung des in diesem Stellglied enthaltenen piezoelektrischen Körpers 1′ wird über den zu schließenden Schalter S1 eine elektrische Spannung $U_H$ angelegt, die z. B. von einer elektrischen Quelle 2 mit einem Innenwiderstand

$R_i$ geliefert wird. Mit Vollendung der Aufladung des Stellglieds 1 hat dieses seinen zweiten mechanischen Stellzustand erreicht. Der anfängliche Zustand ohne Anliegen einer elektrischen Spannung am Stellglied 1 ist hier der erste Stellzustand. Im zweiten Stellzustand ist außer der für die mechanische Arbeit des Stellglieds 1 verbrauchten, von der Quelle 2 zu liefernden elektrischen Energie von dieser noch zusätzlich die in der elektrischen Kapazität des Stellglieds 1 enthaltene Blindenergie zu liefern gewesen, wobei die Blindenergie ein Vielfaches der in entnehmbare mechanische Arbeit umgesetzten elektrischen Energie ist.

Nach Erreichen des zweiten Stellzustands wird der Schalter S1 geöffnet, wobei der zweite Stellzustand im wesentlichen erhalten bleibt. Bei Kurzschließen der Anschlüsse 3 und 4 des Stellglieds 1 miteinander erfolgt ein Ladungsausgleich der Kapazität des Stellglieds 1, womit dieses in den ersten Stellzustand zurückgeht. Der dabei fließende Entladestrom bewirkt bei Kurzschluß die Vernichtung der im Stellglied 1 enthaltenen Blindenergie. Diese soll aber gemäß der Erfindung nicht verlorengehen. Es wird hierzu (bei geöffnetem Schalter S1) der Schalter S2 geschlossen und der Stromfluß über die Induktivität L und den Kondensator C (zum Anschluß 3) führt zu einem nahezu ebenso raschen Abfall des Ladezustands des Stellglieds 1 und gleichzeitig zu einer elektrischen Aufladung des Kondensators C. Wie oben erwähnt, kann die Umladezeit $t_u$ gleich der halben Periodendauer $\frac{1}{f}$ betragen oder länger sein.

Der Entladevorgang des Stellglieds 1 und der Aufladevorgang des Kondensators C hat abhängig von der Induktivität L und den Kapazitätswerten einen zeitlichen Zustand, in dem die elektrische Spannung am Stellglied 1 praktisch gleich Null ist und die gesamte zuvor im Stellglied 1 enthaltene Blindenergie sich im Kondensator C befindet. In diesem Augenblick höchster Aufladespannung des Kondensators C auf den Wert $U_C$ wird der Schalter S2 geöffnet und eine Rückladung auf das Stellglied 1 unterbleibt, so daß der erste (ungeladene) Stellzustand des Stellglieds 1 (wieder) erreicht ist.

Wie bereits oben angegeben, sind die Kapazitätswerte des Stellglieds 1 und des Kondensators C möglichst gleich groß zu wählen. Die Induktivität L und der Kondensator C bilden zusammen mit der elektrischen Kapazität des Stellglieds 1 einen Schwingkreis, in dem die Spannung am Stellglied 1 entsprechend

$$\frac{1}{2} U_B (1 + \cos \omega t)$$

abnimmt und die Spannung am Kondensator C entsprechend

$$\frac{1}{2} U_B (1 - \cos \omega t)$$

zunimmt. Bei gleich großen Kapazitäten von 1 und von C beträgt die Kreisfrequenz

$$\omega = 2\pi f = \frac{1}{\sqrt{L \cdot C/2}}.$$

Der Zeitpunkt der Betätigung des Schalters S2, $t_u$, ist durch die halbe Periodendauer dieser Kreisfrequenz $\omega$ gegeben.

Den (erneuten) Übergang des Stellglieds 1 aus seinem ersten Stellzustand in seinen zweiten Stellzustand erreicht man durch erneutes Schließen des Schalters S2, womit die im Kondensator C gespeicherte elektrische Energie wieder (abgesehen von Leitungsverlusten) voll auf das Stellglied 1 übertragen wird, wobei nach der Zeit $\tau/2$ der Schalter S2 wieder geöffnet wird und worin $\tau$ die der Kreisfrequenz entsprechende Periodendauer ist. Ein nicht zu vermeidender Energieverlust kann durch anschließendes kurzzeitiges Schließen des Schalters S1 ausgeglichen werden, nämlich indem man aus der Quelle 2 soviel Ladung in das Stellglied 1 nachfließen läßt, daß an diesem wieder die ursprüngliche Spannung $U_H$ anliegt. Der Kondensator C ist in diesem Zustand weitgehend entladen.

Eine auf dem Kondensator C dennoch zurückgebliebene Restladung muß durch Schließen des Schalters S3 beseitigt werden. Eine solche Restladung würde sich nämlich akkumulieren und bei abwechselnder Änderung der Stellzustände des Stellglieds 1 das Maß des Unterschieds der Stellzustände voneinander (von mal zu mal) verringern. Die Maßnahme der Beseitigung der Restladung kann auch am Stellglied 1 erfolgen. Es genügt aber, wenn am Kondensator C oder am Stellglied 1, d. h. bei jedem zweiten Stellvorgang, diese Maßnahme durchgeführt wird.

Die Fig. 2 zeigt in sechs Zeilen untereinander parallel zueinander den zeitlichen Ablauf einzelner Funktionen und Vorgänge der Schaltung nach Fig. 1. Auf der Abszisse ist die Zeit aufgetragen. Die erste Zeile zeigt die Funktion des Schalters S1. Die zweite Zeile gibt die Betätigung des Schalters S2 an. Der sich daraus ergebende Aufladezustand des Stellglieds 1, d. h. der Verlauf der am Stellglied anliegenden Spannung $U_1$, gibt Zeile 3 wieder. Zeile 4 zeigt den entsprechenden Spannungsverlauf am Kondensator C und Zeile 5 dazu den Strom I durch die Induktivität L. Die letzte, sechste Zeile gibt den zeitlichen Takt des gegebenenfalls vorgesehenen Schalters S3 wieder.

In den sechs Zeilen ist im linken Teil der Fig. 2 der Zustand der ersten Betätigung des Stellglieds 1 wiedergegeben. Der Zustand der zweiten und jeder weiteren Betätigung nach einmal erfolgter Aufladung des Stellglieds 1 wird durch den mittleren und durch den rechten Teil der Fig. 2 wiedergegeben. Mit dem Bezugszeichen N' ist in Zeile 3 auf die Nachladung des Stellglieds aus der Quelle 2 und mit N'' in Zeile 4 auf die restliche Entladung (Beseitigung der Restladung) des Kondensators C durch Schließen des Schalters S3 (Zeile 6, Fig. 2) hingewiesen.

Fig. 1 zeigt gestrichelt eine Variante, bei der die Quelle 2 und der Schalter S1 der linken Seite der Fig. 1 entfällt und diese Elemente statt dessen parallel dem Kondensator C geschaltet sind. Ihre Funktion ist dabei unverändert, jedoch wird im ersten Betriebsschritt hier der Kondensator C aufgeladen (und das Stellglied 1 verbleibt — wenn der Schalter S2 offenbleibt — in seinem ersten anfänglichen Stellzustand). Die Aufladung des Stellglieds und dessen Übergang in den zweiten Stellzustand erfolgt dann im nächsten Schritt, wenn der Schalter S2 geschlossen wird. Dabei erfolgt hier auch die erste Aufladung vorteilhafterweise bereits aus dem Kondensator C und die Vorgänge laufen ab, wie in Fig. 2 im rechten Teil angegeben und voranstehend erläutert.

Es ist auch noch darauf hinzuweisen, daß in der Schaltung der Fig. 1 — und das gilt auch für die noch nachfolgend beschriebenen Weiterbildungen in den übrigen Figuren — der Platz des Stellglieds 1 und der des Kondensators C (in der Schaltung) miteinander vertauscht werden können. Insbesondere kann der Kondensator C auch ein zweites Stellglied (eines Tandem-Stellglieds) sein, das im Gegentakt, d. h. wechselweise zum ersterwähnten Stellglied 1, zu betreiben und betätigen ist. Was die Restladung betrifft, gilt das oben Gesagte gleichermaßen, d. h. es genügt, jeweils die Restladung entweder am Kondensator C (wie mit Schalter S3 gezeigt) oder am den Kondensator C ersetzenden (weiteren) Stellglied zu beseitigen.

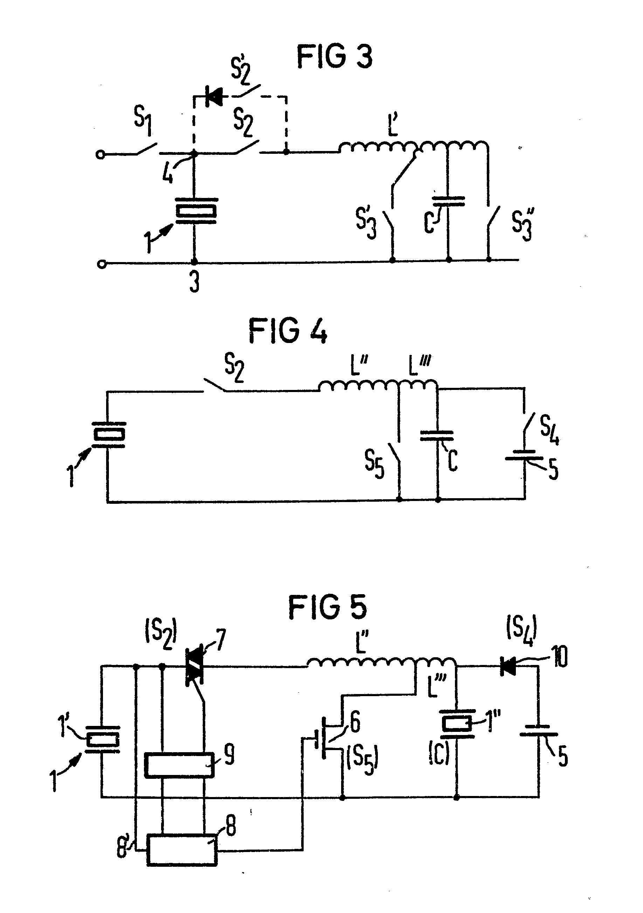

Fig. 3 zeigt eine vorteilhafte Weiterbildung des erfindungsgemäßen Prinzips nach Fig. 1. Bereits zur Fig. 1 beschriebene Einzelheiten haben in Fig. 3 dieselben Bezugszeichen. In Fig. 3 sind zwei Schalter S3, nämlich S3' und S3'', angegeben. Der Schalter S3' ist an einer Zwischenanzapfung der Induktivität 11' angeschlossen. Der Schalter S3'' ist an einer Fortsetzung der Induktivität L' angeschlossen. Die beiden Schalter S3' und S3'' kommen wahlweise je nach Polarität in Betracht, wie es noch näher erläutert wird.

Nachfolgend wird die Funktion des Schalters S3 in der Version S3' erläutert:

Das anfängliche Aufladen des Stellglieds 1 über den Schalter S1, das Entladen desselben über den Schalter S2 und das Rückaufladen des Stellglieds 1 aus dem Kondensator C über die Induktivität L' und den Schalter S2 läuft in der zu den Fig. 1 und 2 beschriebenen Weise ab. Beim Beispiel der Fig. 1 wurde beim Schließen des Schalters S3 die Restaufladung der Kapazität C vernichtet. Bei der Verbesserung nach Fig. 3 wird jedoch bei Schließen des Schalters S3' in die Induktivität L' eine Spannung induziert, die entsprechend dem wie ersichtlichen Übersetzungsverhältnis transformiert über den dann zu schließenden Schalter S2 zusätzlich auf das Stellglied 1 übertragen werden kann, d. h. diesem eine restliche Aufladung gibt. Es kann damit ein Anteil der z. B. in der Fig. 1 beschriebenen Nachladung aus der Quelle 2 ersetzt werden.

Eine Vereinfachung im Detail ergibt sich, wenn man — wie gestrichelt angedeutet — den Schalter S2 durch den Schalter S2' mit einer in Reihe geschalteten Diode ersetzt, wobei die Diode für Ladungstransport von dem Kondensator C auf das Stellglied 1 durchlässig geschaltet ist. Die Diode verhindert die entsprechende Rückumladung während der Schließungszeit des Schalters S2'. Bei entgegengesetzter Polarität der Restladung aus dem Kondensator C wird der Schalter S3'' benutzt. Dabei wird eine phasenentgegengesetzte Spannungsübersetzung in der Induktivität L', d. h. eine phasenrichtige Nachladung des Stellglieds 1, erreicht.

Auch für die Schaltung nach Fig. 3 gelten die oben erwähnten Varianten, insbesondere der Vertauschung der Plätze von Stellglied und Kondensator in dieser Schaltung sowie der Anschluß von zwei Stellgliedern (ein zweites Stellglied anstelle des Kondensators C) in dieser Schaltung und die Einspeisung aus einer Quelle 2, die parallel zum Kondensator C bzw. parallel zum Schalter S3'' angeschlossen ist.

Fig. 4 zeigt eine besondere Weiterbildung der Erfindung, und zwar insbesondere der Ausführungsform nach Fig. 3. Die Ausführungsform nach Fig. 4 eignet sich besonders für die Anwendung der Erfindung in Fahrzeugen, in denen als Energiequelle eine Batterie mit z. B. 12 Volt Gleichspannung zur Verfügung steht, aus der heraus ein (in diesem Fahrzeug, insbesondere am Motor) befindliches piezoelektrisches Stellglied zu speisen ist. Mit der Beschreibung der vorangehenden Figuren bereits erwähnte Einzelheiten haben in Fig. 4 dieselben Bezugszeichen. Mit 5 ist die (Fahrzeug-)Batterie bezeichnet.

In der ersten Betriebsphase dieser Ausführungsform sind die Schalter S4 und S5 geschlossen. Aus der Batterie 5 werden die Induktivität L'' und der Kondensator C aufgeladen. In der folgenden Betriebsphase wird der Schalter S5 geöffnet und der Schalter S2 geschlossen, wobei der Schalter S4 zunächst geschlossen bleibt. Da der in der Induktivität L'' zuvor fließende Strom die Tendenz hat weiterzufließen, wird die Kapazität des Stellglieds 1 aufgeladen und dabei das Feld der Induktivität L'' abgebaut. Sobald jedoch der Strom in die Kapazität des Stellglieds 1 auf den Wert Null fällt und bevor der Strom beginnt, rückwärts wieder aus dem Stellglied 1 herauszufließen, wird der Schalter S2 wieder geöffnet und das Stellglied 1 bleibt aufgeladen, d. h. ist von seinem zuvor spannungslosen ersten Betriebszustand in seinen aufgeladenen zweiten Betriebszustand gebracht worden. Falls in der Anfangsphase das Stellglied 1 durch den einen vorstehend beschriebenen Schaltprozeßschritt noch nicht voll aufgeladen ist, kann dieser Prozeßschritt iterativ wiederholt werden, bis gewünschte Aufladung erreicht ist.

Der weitere Betrieb der Schaltung, nach Fig. 4, d. h. die Rückführung des Stellglieds 1 in den ersten, ungeladenen Betriebszustand, erfolgt wieder durch Schließen des Schalters S2 mit dem Funktionsablauf, wie er zu den vorangehenden Ausführungsformen beschrieben ist. Während dieser Phase ist der Schalter S5 geöffnet.

Eine nächste Wiederaufladung der Kapazität des Stellgliedes 1 erfolgt jetzt vorwiegend aus dem Kondensator C, wozu der Schalter S2 bis zum Null-Durchgang des Aufladestromes geschlossen wird. Eine Nachladung zum Ausgleich des Ladeverlustes erfolgt durch Schließen der Schalter S4 und S5, wie oben beschrieben.

Die Schaltung nach Fig. 4 kann auch in etwas abgewandelter Weise betrieben werden, nämlich indem in der ersten Phase zunächst die Schalter S4, S5 und auch S2 geschlossen werden. Die Speisespannung wird in der als Transformator wirkenden Induktivität L'' übersetzt, um die benötigte Hochspannung zu erzeugen. Sobald dieser Aufladestrom des Stellgliedes 1 den Null-Durchgang erreicht hat oder sobald der piezoelektrische Körper 1' des Stellgliedes 1 auf die für die geforderte Längenänderung notwendige Spannung aufgeladen worden ist, öffnet man die Schalter S2 und S5. Das Stellglied 1 verbleibt wiederum in seinem zweiten aufgeladenen Betriebszustand.

In der Ausführungsform nach Fig. 4 wird somit erstmalige Erzeugung und Nachlieferung der notwendigen elektrischen Energie während des Betriebs aus der vorgesehenen Batterie bewirkt.

Die Verwertung der nach Umladen auf das Stellglied 1 im Kondensator C verbleibenden Restladung ist bei der Ausführungsform nach Fig. 4 durchführbar, soweit die elektrische Spannung der Restladung den Wert der Nenn-Spannung der Batterie 5 übersteigt. Wenn nun das bereits aufgeladene Stellglied 1 wieder in seinen ersten ungeladenen Betriebszustand bei geschlossenem Schalter S2 und offenem Schalter S4 zurückgeführt wird, wird die zuvor im Stellglied 1 gespeicherte elektrische Energie auf den Kondensator C umgeladen. Für erneute Aufladung des Stellgliedes 1 wird wieder der Schalter S2 geschlossen und die elektrische Energie aus dem Kondensator C fließt wieder in das Stellglied 1. Die in dem Kondensator C verbleibende Restladung kann dadurch auf das Stellglied zusätzlich übertragen werden, indem der Schalter S5 geschlossen wird. Der Schalter S4 bleibt dabei noch offen, nämlich bis die Spannung an dem Kondensator C auf den Wert der Spannung der Batterie 5 abgefallen ist. Erst dann wird der Schalter S4 geschlossen und erst dann erfolgt die Nachladung, d. h. die Kompensation zuvor eingetretener Verluste aus der Batterie 5. Die weiteren Phasen laufen dann wie beschrieben ab.

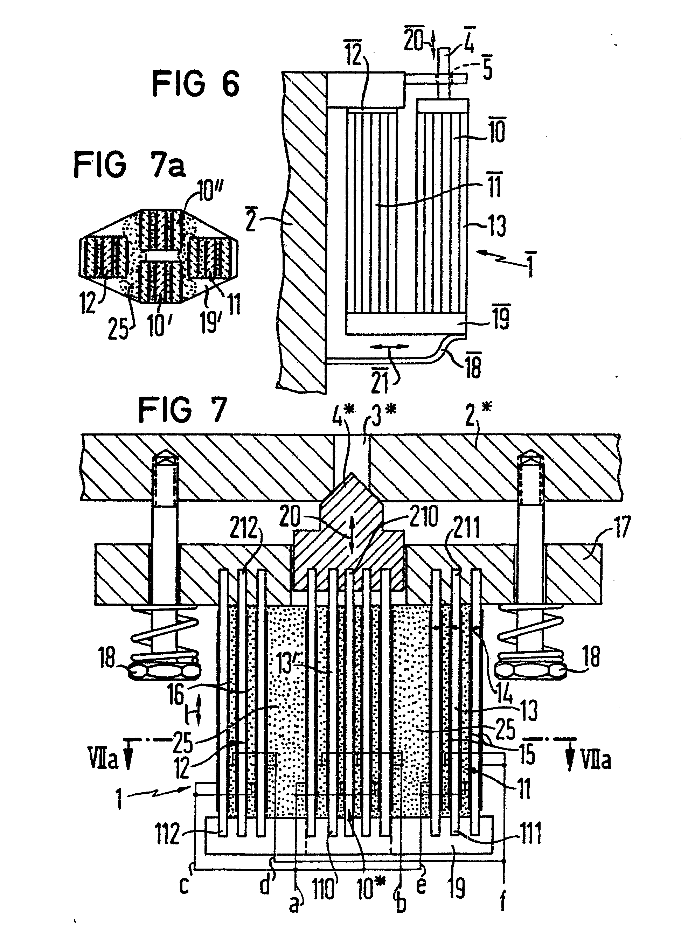

In Fig. 5 ist eine praktische Ausführung einer erfindungsgemäßen Schaltung angegeben, und zwar für ein Tandem-Stellglied nach der Europäischen Patentanmeldung 0 054 704-A3, deren Einzelheiten — soweit vorangehend beschrieben — mit den Fig. 1 bis 4 übereinstimmende Bezugszeichen haben. Der Schalter S4 der Fig. 4 ist in Fig. 5 eine Diode. Der Schalter S5 ist in Fig. 5 ein spannungsfester Transistor, z. B. ein MOS-Leistungstransistor.

Der Schalter S2 ist in Fig. 5 ein Triac 7 oder eine Antiparallelschaltung zweier Thyristoren, der bzw. die von einem Steuerglied 8 in derjenigen Taktfolge angesteuert werden, die für die Tätigkeit des Stellgliedes 1 vorgeschrieben ist. Mit 9 ist ein galvanisch trennender Zündkoppler, beispielsweise ein Piezo-Zündkoppler, nach den DE-A-3 015 301 und DE-A-3 035 503 bezeichnet. Die Leitung 8' dient zum Abgriff und zur Kontrolle der erreichten Aufladespannung. Durch gleichzeitiges Ansteuern des Triacs bzw. der Thyristoren 7 und des Schalters S5 kann eine erstmalige Aufladung vorgenommen werden. Durch sukzessiv taktweises gleichzeitiges Ansteuern der Schalter S2 und S5 kann iterativ eine Aufladung auf den Maximalwert erreicht werden.

Der Kondensator C ist hier ein zum piezoelektrischen Körper 1' gegenphasig zu betreibender zweiter piezoelektrischer Körper 1''.

Die Fig. 6 und 7 zeigen bevorzugte Anwendungsfälle für eine erfindungsgemäße Schaltungsanordnung, nämlich bei einem Stellglied mit im einen Falle zwei gegenphasig zu betreibenden piezoelektrischen Körpern (Fig. 6) und im anderen Falle mit zwei Gruppen piezoelektrischer Körper (von denen die eine Gruppe beim dargestellten Beispiel nur einen piezoelektrischen Körper (10*) hat), die gruppenweise gegenphasig zu betreiben sind.

Fig. 6 zeigt eine erste Ausführungsform eines vorgesehenen Stellglieds $\bar{1}$. Es besteht aus zwei piezoelektrischen Körpern $\overline{10}$, $\overline{11}$, die aus piezoelektrischen Lamellen 13 aufgebaut sind. Einzelheiten eines solchen Aufbaues sind bereits in der DE-A-3 040 563 beschrieben. Das in der Fig. 6 obere Ende des piezoelektrischen Körpers $\overline{11}$ ist mit der Vorrichtung $\bar{2}$ verbunden, an der bzw. in der das erfindungsgemäße Stellglied $\bar{1}$ anzubringen ist. Diese Verbindungs- bzw. Anbringungsstelle ist der Befestigungsort $\overline{12}$ des Stellglieds $\bar{1}$. Mit $\overline{19}$ ist eine Traverse bezeichnet, an der das dem Befestigungsort $\overline{12}$ gegenüberliegende Ende des piezoelektrischen Körpers $\overline{11}$ und seitlich daneben das untere Ende des zweiten piezoelektrischen Körpers $\overline{10}$ befestigt sind, so daß die beiden piezoelektrischen Körper $\overline{10}$ und $\overline{11}$ und die Traverse $\overline{19}$ zusammen ein festes biegesteifes Teil sind. Das in der Fig. 1 obere Ende des piezoelektrischen Körpers $\overline{10}$ ist der Wirkungsort des Stellglieds $\bar{1}$, an dem beispielsweise ein Stößel $\bar{4}$ befestigt ist, der die Hub-Arbeit des dargestellten Stellglieds $\bar{1}$ abgibt. Mit dem Doppelpfeil $\overline{20}$ ist der Hub bzw. diese Hub-Arbeit des Stellglieds $\bar{1}$ angedeutet. Mit $\overline{18}$ ist eine an der Vorrichtung $\bar{2}$ und an der Traverse $\overline{19}$ befestigte Blattfeder bezeichnet, die mit dem Doppelpfeil $\overline{21}$ auftretende Kraftwirkungen aufnimmt. Ohne die Blattfeder $\overline{18}$ würde das erfindungsgemäße Stellglied $\bar{1}$ bzw. die Traverse $\overline{19}$ in den Richtungen des Doppelpfeils $\overline{21}$ ausweichende Bewegungen ausführen. In zum Doppelpfeil $\overline{21}$ senkrechter Richtung übt die Blattfeder $\overline{18}$ keinen nennenswerten Widerstand auf eine Bewegung der Traverse $\overline{19}$ aus.

Das dargestellte Stellglied $\bar{1}$ mit seinen zwei piezoelektrischen Körpern $\overline{10}$ und $\overline{11}$ arbeitet nach dem Tandem-Prinzip, d. h. die beiden piezoelektrischen Körper $\overline{10}$, $\overline{11}$ sind elektrisch so geschaltet, daß im einen Stellzustand der eine piezoelektrische Körper (beispielsweise $\overline{10}$) maximale Kontraktion und der andere piezoelektrische Körper (beispielsweise $\overline{11}$) maximale Dilatation hat. In diesem Falle ragt der in der Bohrung $\bar{5}$ geführte Stößel $\bar{4}$ nur minimal über den oberen Rand dieser Führung 5 heraus. Im entgegengesetzten Stellzustand mit maximaler Dilatation des piezoelektrischen Körpers $\overline{10}$ und maximaler Kontraktion des anderen piezoelektrischen Körpers $\overline{11}$ ragt der Stößel $\bar{4}$ maximal weit über den oberen Rand der Bohrung $\bar{5}$ heraus. Bei piezoelektrischer Keramik und einem wie angegebenen Lamellen-Aufbau der piezoelektrischen Körper hat ein solcher maximale Kontraktion, d. h. geringste Länge im aufgeladenen Zustand und im elektrisch entladenen Zustand seine größte Längenabmessung, d. h. maximale Dilatation.

Einzelheiten über den elektrischen Betrieb eines solchen Stellgliedes $\bar{1}$ gehen aus der Beschreibung hervor, die sich dann auch auf die Ausführungsform eines weiteren Stellgliedes beziehen.

Fig. 7 zeigt einen prinzipiellen Aufbau eines weiteren Stellgliedes 1. Mit 2* ist die Vorrichtung bezeichnet, an der das Stellglied anzubringen ist. Es ist dies z. B. ein Anteil der Gehäusewand eines Einspritzventils. Dieses hat eine Ventilöffnung 3*, in der wiederum sich der am aktiven Ende des Stellgliedes befestigte Ventilkegel 4* befindet. Mit 10*, 11 und 12 sind drei Körper bezeichnet, die aus piezoelektrischen Lamellen 13, 13' aufgebaut sind. Wie dies wiederum bereits in der DE-A-3 040 563 beschrieben ist, können die einzelnen piezoelektrischen Körper 10*, 11, 12 nach unterschiedlichen Prinzipien aufgebaut sein, z. B. mit unmittelbar aufeinanderliegenden Lamellen 13, 13' oder mit Lamellen 13, 13', zwischen denen sich inaktive Zwischenlagen befinden. Die einzelnen Lamellen 13, 13' eines jeweiligen Körpers 10*, 11, 12 sind mit ihren (zur Darstellungsebene der Fig. 7 senkrechten) Hauptflächen derart fest miteinander verbunden, daß die Lamellen 13, 13' gegeneinander nicht verschiebbar sind. Mit den Pfeilen 14 ist die eingeprägte elektrische Polarisation der einzelnen Lamellen 13, 13' bezeichnet. Zwischen den Lamellen 13, 13' eines jeweiligen Körpers 10*, 11, 12 und auf den äußeren Hauptflächen derselben sind Elektroden-Belegungen, z. B. in der Form aufgesputterter Metallisierungen 15 der Keramikoberfläche, aufgebracht. Mit dem Bezugszeichen 16 ist auf die zwischen den Lamellen 13, 13', d. h. zwischen den einander gegenüberliegenden Metallisierungen 16, befindlichen Schichten hingewiesen, die die mechanische Verbindung jeweils benachbarter Lamellen 13, 13' miteinander bewirken. Die Schichten 16 können vorzugsweise Klebstoff sein. Es kann aber auch eine Lotschicht einer Verlötung benachbarter Metallisierungsschichten 15 sein. Weiter können diese einzelnen (Abstands-)Schichten 16 auch Klebfolien sein, wie z. B. das glasfaserverstärkte Epoxid-Material »Prepreg« der Fa. Ciba.

Es ist ein Körper 10* zwischen wenigstens zwei weiteren Körpern 11 und 12 angeordnet. Die in der Fig. 1 oberen Enden 211 und 212 der beiden außenliegenden Körper 11 und 12 sind mit einem Teil 17 z. B. durch Ankleben, Anschrauben oder dergleichen fest verbunden, wobei dieses Teil 17 auch ein Anteil der Gehäusewand 2* sein kann oder vorzugsweise — wie dargestellt — mit Schrauben 18 an der Gehäusewand 2* einstellbar und justierbar befestigt ist. Die in der Darstellung der Fig. 6 unteren Enden 110, 111, 112 der Körper 10*, 11, 12 sind durch eine biegesteife Traverse 19 miteinander verbunden. Eine Dilatation der Körper 11 und 12 durch Wegnahme einer zuvor in polarisationsunterstützender Richtung angelegten elektrischen Spannung führt zu einer (in der Fig. 6) Abwärtsbewegung der Traverse 19. Da symmetrischer Aufbau mit zwei Körpern 11 und 12 vorliegt, wirkt auf die Traverse 19 keinerlei Dreh- oder Kippmoment. Mit der Dilatation der Körper 11 und 12 wird das untere Ende 110 des Körpers 10* heruntergezogen. Bei zusätzlicher gegensinniger Bewegung, nämlich Kontraktion, des Körpers 10* durch Anlegen einer polarisationsunterstützenden Spannung wird das Teil 4*, das mit dem oberen Ende 210 des Körpers 10* fest verbunden ist, herabbewegt. Die Dilatation der Körper 11 und 12 und die vorzugsweise gleichzeitig ausgeführte Kontraktion des Körpers 10* führt additiv zu einer verdoppelten Hub-Bewegung des Teils 4*, wie sie mit dem nach unten gerichteten Pfeil des Doppelpfeils 20 angedeutet ist. Kontraktion der Körper 11 und 12 und vorzugsweise gleichzeitige Dilatation des Körpers 10* führt zu entsprechend nach oben gerichteter, mit dem oberen Ende des Doppelpfeils 20 angedeuteter Bewegung des Teils 4*.

Der wie dargestellte und beschriebene symmetrische Aufbau führt zu reiner Longitudinalbewegung des Teils 4* und es sind Kipp- oder Schwenkbewegungen vermieden. Ein entsprechendes Ergebnis wird auch mit drei, vier oder mehr außenliegenden Körpern erreicht, wie sie durch die Körper 11 und 12 repräsentiert sind. Eine andere Variante des Aufbaus kann statt des vorangehend beschriebenen nur einen Körpers in der Mitte auch zwei (noch mehrere) zwischen den Körpern 11 und 12 liegende, symmetrisch angeordnete Körper haben, die beide gleichsinnig wirksam sind. Bei einer solchen Ausführungsform ist sozusagen der eine mittlere Körper 10* in zwei Einzelkörper aufgeteilt, die einen Abstand voneinander haben können und die wiederum symmetrisch zu den außenliegenden, jeweils gegensinnig arbeitenden Körpern angeordnet sind. Die oben beschriebene, vorzugsweise streifenförmige Traverse 19 muß dann entsprechend große Grundfläche haben, um alle unteren Enden aller Körper aufnehmen zu können, und sie muß auch entsprechend ausreichend biegesteif sein. Eine solche Ausführungsform mit zwei innenliegenden Körpern kann insoweit vorteilhaft sein, als diese beiden innenliegenden Körper und zwei zugehörige außenliegende Körper 11 und 12 für sich identischen Aufbau haben können und damit für die innenliegenden Körper einerseits und die außenliegenden Körper andererseits gleich große elektrische Kapazität vorliegt.

Der prinzipielle Aufbau nach Fig. 7 kann im Detail in noch weiter mehrfach variierter Ausführungsform ausgestaltet sein, nämlich je nachdem auf welch einen oder mehreren Vorteile der insgesamt mit dem erfindungsgemäßen Prinzip gebotenen Vorteile besonderes Gewicht gelegt wird. Es kann z. B. auf optimale Kraftwirkung bzw. optimale Kraftausnutzung vorrangig Wert gelegt sein. Für andere Anwendungsfälle kann insbesondere rasches Ansprechen und rasche Ausführung der Dilatations- und Kontraktions-Bewegung, z. B. für rasches Öffnen und Schließen eines Ventils, besonders wichtig sein. Für den ersteren Fall empfiehlt es sich, den aktiven Querschnitt aller piezokeramischer Lamellen 13 des innenliegenden Körpers 10* und die Summe der aktiven Querschnitte aller piezokeramischen Lamellen 13' der beiden Körper 11 und 12 zusammengenommen gleich groß zu machen.

Unter aktivem Querschnitt der piezokeramischen Lamelle 13, 13' ist dabei diejenige Querschnittsfläche zu verstehen, die senkrecht zur Darstellungsebene der Fig. 1 und senkrecht zur (mit der Metallisierung 15 belegten) Hauptfläche der Lamellen 13, 13' liegt. Das heißt, die Flächennormale der jeweils angesprochenen Querschnittsfläche ist parallel zu der mit dem Doppelpfeil 1 bezeichneten Längsrichtung dieser Lamellen 13, 13'. Die (allerdings ohnehin nur sehr dünnen) Metallbelegungen 15 und die beispielsweise aus Klebstoff bestehenden Zwischenschichten 16 und eventuell zusätzlich noch vorgesehene, in der Figur nicht dargestellten Zwischenlagen bzw. Distanzschichten oder -folien sind piezoelektrisch inaktiv. Die jeweils angegebene Summe der Querschnitte bezieht sich daher allein auf die piezokeramischen Querschnitte der Lamellen 13, 13'. Es ist hierfür der Begriff »aktiver« Querschnitt verwendet.

Bei der voranstehend erläuterten Ausführungsform mit gleich großem aktiven Querschnitt für den innenliegenden Körper 10* und für die Summe der außenliegenden Körper 11 und 12 teilt sich die Krafterzeugung und der Hub und damit die Arbeit zu gleichen Teilen auf diesen innenliegenden Körper 10* und auf die Gesamtheit der außenliegenden Körper 11 und 12 auf. Auch die elektrischen Kapazitäten des Körpers 10* einerseits und der Gesamtheit der Körper 11 und 12 andererseits sind gleich groß. Es sind damit die beiden Energiespeicher ebenfalls gleich groß und wegen des gegensinnigen Betriebs dieser beiden Anteile des dargestellten Stellglieds ist es hier möglich, die für den Betrieb des Stellglieds notwendige elektrische Anregungsenergie vom einen Energiespeicher zum anderen Energiespeicher hin- und herfließen zu lassen. Erfolgt dieses Hin- und Herfließenlassens über eine angepaßte bemessene Induktivität — und natürlich über einen damit in Reihe liegenden steuerbaren Schalter — so kann ein praktisch verlustloser Hin- und Hertransport der vollständigen für den Stellbetrieb notwendigen Energie erfolgen. Will man bei dieser Ausführungsform nur einheitlich ausgebildete Körper verwenden, kann für den innenliegenden Körper 10 die bereits oben beschriebene Variation vorgesehen werden, nämlich anstelle dieses in der Fig. 1 dargestellten einzigen Körpers 10* nebeneinandergeordnet und mechanisch parallelgeschaltet zwei solche Körper zu verwenden, wie sie für die Körper 11 und 12 vorgesehen sind.

Für eine dagegen sehr rasche Bewegung des Teils 4*, z. B. des Kegels eines Ventils, empfiehlt es sich, von den beiden mechanisch hintereinandergeschalteten Anteilen des dargestellten Stellglieds — nämlich von dem einerseits durch die Körper 11 und 12 gebildeten Anteil und dem andererseits durch den Körper 10 gebildeten Anteil — denjenigen Anteil mit geringerer Masse auszubilden, der im mechanischen Kraftfluß dem zu bewegenden Teil 4* näher liegt. Es ist dies bei der Darstellung der Fig. 7 der Körper 10*. Zum Beispiel kann als Körper 10 ein einziger mit den Körpern 11 und 12 identischer Körper verwendet werden, der dann entsprechend nur die halbe träge Masse der Körper 11 und 12 zusammengenommen hat. Dieser leichtere Körper 10* kann mit gleich großer Kraft entsprechend schneller — nämlich doppelt so schnell — beschleunigt werden, so daß nahezu doppelt so große Ansprechgeschwindigkeit für das Teil 4* erreicht ist. Es ist lediglich in Kauf zu nehmen, daß von dem in dieser Weise bemessenen innenliegenden Körper entsprechend geringere Stellkraft zur Gesamtsumme der Stellkräfte des ganzen erfindungsgemäßen Stellglieds beigetragen wird. Verwendet man wie bei dieser Ausführungsform für die drei in der Fig. 7 dargestellten Körper in derartiger Weise drei identische lamellierte Körper, so hat der innenliegende, zu den Körpern 11 und 12 gegensinnig arbeitende lamellierte Körper eine nur halb so große elektrische Kapazität. Für ein wie voranstehend beschriebenes vollständiges Umladen der elektrischen Anregungsenergie ist in diesem Fall dem innenliegenden Körper des Stellglieds ein entsprechender elektrischer Zusatzkondensator parallel zu schalten.

Voranstehend sind zwei Varianten beschrieben, nämlich mit gleich großem aktiven Querschnitt der Summe der außenliegenden Körper 11, 12 einerseits und dem einen (oder der Summe des aufgeteilten einen) innenliegenden Körper 10*. Die zweite spezielle beschriebene Ausführungsform hat doppelt so große Kapazität für die beiden außenliegenden Körper 11, 12. Im ersteren Falle ist optimale Stellkraft und vollständiger Ladungsausgleich für ein Umladen gegeben. Im zweiten Fall erhält man ein Stellglied, das höhere Arbeits- und Ansprechgeschwindigkeit hat. Kompromißlösungen liegen zwischen diesen beiden Fällen, wenn das Verhältnis der Summe der aktiven Querschnitte der außenliegenden Körper zum aktiven Querschnitt des innenliegenden Körpers zwischen den Werten 1 und 2 liegt.

Die Fig. 7 zeigt zusätzlich mit den Leitungen der Bezugszeichen a bis f ein elektrisches Schaltungsbeispiel für die Lamellen 13, 13'. Einander jeweils gegenüberliegende Elektroden-Belegungen 15 sind elektrisch miteinander verbunden. In einander benachbarten Lamellen 13, 13' liegt jeweils entgegengesetzte Polarisationsrichtung im piezoelektrischen Material in Richtung der Dicke der Lamellen vor. Wie dargestellt, sind miteinander verbundene innenliegende Elektroden-Belegungen 15 mit je einer außenliegenden Elektroden-Belegung 15 verbunden. Der piezoelektrische Körper 10 hat die nach außen geführten Anschlüsse a und b. Die beiden piezoelektrischen Körper 11 und 12 haben die nach außen geführten Anschlüsse e und f sowie c und d. Entsprechend der Zusammenschaltung der piezoelektrischen Körper 11 und 12 als eine Gruppe A sind die Außenanschlüsse d und f einerseits und die Außenanschlüsse c und e andererseits miteinander verbunden. Als Masse-Anschluß sind die Anschlüsse c und e auch mit dem Anschluß a des gegenphasig zu betreibenden piezoelektrischen Körpers 10 verbunden. Der äußere Anschluß b des piezoelektrischen Körpers 10, der hier die Gruppe B bildet, ist galvanisch getrennt von dem gemeinsamen Außenanschluß f der piezoelektrischen Körper 11 und 12 der Gruppe A.

Fig. 7a zeigt eine Variante mit zwei innenliegenden piezoelektrischen Körpern 10', 10'' (statt eines einzigen Körpers 10). Bei dieser Variante können vorteilhafterweise vier identische Körper verwendet werden, wobei die Körper 10', 10'' die Gruppe B und die Körper 11, 12 die Gruppe A mit jeweils gleich großen Kapazitäten bilden.

**Patentansprüche**

1. Schaltungsanordnung an einem abwechselnd aufzuladenden und zu entladenden piezoelektrischen Körper, z. B. einem piezoelektrischen Stellglied, insbesondere zur gegenphasigen Auf- bzw. Entladung mindestens zweier piezoelektrischer Körper, dadurch gekennzeichnet, daß an die Anschlüsse (3, 4) wenigstens eines piezoelektrischen Körpers (1') eine Reihenschaltung aus einem kapazitiven Element (C; 1''), insbesondere einem zweiten piezoelektrischen Körper (1''), einer Induktivität (L) und einem steuerbaren ersten Schalter (S2; 7) angeschlossen ist, wobei die Kapazität dieses Elements (C; 1'') wenigstens nahezu gleich groß der Kapazität des piezoelektrischen Körpers (1') zwischen den Anschlüssen (3, 4) ist, wobei die Induktivität (L) so bemessen ist, daß sie die gesamte zwischen den Anschlüssen (3, 4) des piezoelektrischen Körpers und dem kapazitiven Element (C; 1'') umzuladende Energie magnetisch zwischenspeichern kann, und wobei der erste Schalter (S2, 7) zum Unterbrechen des Ladungstransports des jeweiligen Umladestromes vorgesehen ist, daß parallel zu den Anschlüssen (3, 4) des piezoelektrischen Körpers oder parallel zum kapazitiven Element (C; 1'') eine Reihenschaltung aus einer elektrischen Energiequelle (2; 5) zum erstmaligen Aufladen und zur Nachladung des piezoelektrischen Körpers bzw. des kapazitiven Elements und aus einem steuerbaren zweiten Schalter (S1; S4; 10) angeschlossen ist, und daß parallel zu den genannten Anschlüssen (3, 4) oder parallel zum kapazitiven Element (C; 1'') ein steuerbarer Kurzschlußschalter (S3; S3', S3''; S5, 6) angeordnet ist.

2. Schaltungsanordnung nach Anspruch 1, dadurch gekennzeichnet, daß das kapazitive Element ein zweiter, zum piezoelektrischen Körper (1') gegenphasig zu betreibender piezoelektrischer Körper (1'') ist.

3. Schaltungsanordnung nach Anspruch 1 oder 2, dadurch gekennzeichnet, daß die Induktivität (11') eine Anzapfung zum Anschluß des Kurzschlußschalters (S3'; S5; 6) hat.

4. Schaltungsanordnung nach Anspruch 1, 2 oder 3, dadurch gekennzeichnet, daß die Spannungsquelle eine Batterie (5) ist.

5. Schaltungsanordnung nach Anspruch 4, dadurch gekennzeichnet, daß die Batterie (5), der zweite Schalter (S4; 10), der Kurzschlußschalter (S5; 6), die Induktivität (L''') der Anzapfung und die Gesamtinduktivität (L'') einen Spannungswandler für die Umwandlung der elektrischen Spannung der Batterie (5) in die erforderliche Hochspannung (U$_H$) bilden (Fig. 4 und 5).

6. Schaltungsanordnung nach einem der Ansprüche 1 bis 5, dadurch gekennzeichnet, daß der erste Schalter (S2) ein Triac (7) oder eine Antiparallelschaltung aus zwei Thyristoren ist.

7. Schaltungsanordnung nach einem der Ansprüche 1 bis 6, dadurch gekennzeichnet, daß der zweite Schalter (S4) eine Diode (10) ist.

8. Schaltungsanordnung nach einem der Ansprüche 1 bis 7, dadurch gekennzeichnet, daß der Kurzschlußschalter (S3'; S5) ein spannungsfester Transistor (6) ist.

9. Schaltungsanordnung nach einem der Ansprüche 1 bis 8, dadurch gekennzeichnet, daß eine Steuerschaltung (8) vorgesehen ist, die zur Ansteuerung des ersten Schalters (S2) und des Kurzschlußschalters (S3', S5) mit diesen verbunden ist (Fig. 5).

10. Verfahren zum Betrieb einer Schaltungsanordnung nach einem der Ansprüche 1 bis 9, dadurch gekennzeichnet, daß der erste Schalter (S2; 7) erst dann geschlossen wird, wenn der Kurzschlußschalter (S5; 6) geöffnet wird.

11. Verfahren zum Betrieb einer Schaltungsanordnung nach einem der Ansprüche 5 bis 9, dadurch gekennzeichnet, daß der erste Schalter (S2; 7) und der Kurzschlußschalter (S5; 6) in der Phase der erstmaligen Aufladung bzw. der Nachladung gleichzeitig geschlossen werden.

12. Verfahren zum Betrieb nach einem der Ansprüche 10 oder 11, dadurch gekennzeichnet, daß das Maß der Aufladung des piezoelektrischen Körpers (1') und/oder des kapazitiven Elements (C; 1'') durch die Schließdauer des Kurzschlußschalters (S5; 6) bemessen wird.

13. Verfahren zum Betrieb nach Anspruch 11 und 12, dadurch gekennzeichnet, daß nach Erreichen der Aufladespannung des piezoelektrischen Körpers (1') und/oder des kapazitiven Elements (C; 1'') der Kurzschlußschalter (S5; 6) geöffnet wird.

14. Anwendung einer Schaltungsanordnung und Betrieb derselben nach einem der Ansprüche 1 bis 13 für ein piezoelektrisches Stellglied mit wenigstens zwei etwa gleich langen piezokeramischen Körpern (10*, 10', 11'', 11, 12; $\overline{10}$, $\overline{11}$), die nebeneinanderliegend angeordnet sind und an einem ihrer jeweils benachbarten Enden durch eine Traverse ($\overline{19}$) miteinander verbunden sind und die elektrisch in zwei Grupen (10 und 11; 10, 10', 10'' und 11, 12) aufgeteilt sind, wobei alle piezoelektrischen Körper der einen Gruppe phasenentgegengesetzt den piezoelektrischen Körpern der anderen Gruppe betrieben werden, wobei die piezoelektrischen Körper der einen Gruppe als das kapazitive Element (C) geschaltet sind und wobei zwischen deren benachbarten anderen Enden ($\overline{12}$, $\overline{4}$; 210, 211 mit 212) die aus dem gegenphasigen Betrieb sich ergebende Relativbewegung (20, $\overline{20}$) abzunehmen ist.

**Claims**

1. A circuit arrangement in a piezoelectric body which is to be alternately charged and discharged, e. g. a piezoelectric control element, in particular for the phase-opposed charging and discharging of at least two piezoelectric bodies, characterised in that the terminals (3, 4) of at least one piezoelectric body (1') are connected to a series arrangement consisting of a capacitive element (C; 1''), in particular a second piezoelectric body (1''), an inductance (L) and a controllable first switch (S2; 7) that the capacitance of this element (C; 1'') is at least approximately equal to the capacitance of the piezoelectric body (1') between the terminals (3, 4), that the inductance (L) is contrived to be such that it is capable of intermediately storing magnetically the entire energy which is to be transferred between the terminals (3, 4) of the piezoelectric body and the capacitive element (C; 1''), and that the first switch (S2; 7) serves to interrupt charge transportation by the respective charge-transfer current;
that parallel to the terminals (3, 4) of the piezoelectric body or parallel to the capacitive element (C; 1'') there is connected a series arrangement of an electrical energy source (2; 5) for the initial charging and subsequent recharging of the piezoelectric body and of the capacitive element, together with a second controllable switch (S1; S4; 10), and that a controllable short-circuit switch (S3;

S3', S3''; S5, 6) arranged parallel to the aforementioned terminals (3, 4) or parallel to the capacitive element (C; 1'').

2. A circuit arrangement as claimed in Claim 1, characterised in that the capacitive element is a second piezoelectric body (1'') operated in phase-opposition to the one piezoelectric body (1').

3. A circuit arrangement as claimed in Claim 1 or 2, characterised in that the short-circuit switch (S3'; S5; 6) has a terminal connected to a tapping of the inductance (11').

4. A circuit arrangement as claimed in Claim 1, 2 or 3, characterised in that the voltage source is a battery (5).

5. A circuit arrangement as claimed in Claim 4, characterised in that the battery (5), the second switch (S4; 10), the short-circuit switch (S5; 6), the inductance (L''') of the tapping, and the overall inductance (L'') together form a voltage transformer for raising the electrical voltage of the battery (5) to the required high voltage ($U_H$) (Fig. 4 and 5).

6. A circuit arrangement as claimed in one of Claims 1 to 5, characterised in that the first switch (S2) consists of a triac (7) or an anti-parallel arrangement of two thyristors.

7. A circuit arrangement as claimed in one of Claims 1 to 6, characterised in that the second switch (S4) is a diode (10).

8. A circuit arrangement as claimed in one of Claims 1 to 7, characterised in that the short-circuit switch (S3'; S5) is a voltagestable transistor (6).

9. A circuit arrangement as claimed in one of Claims 1 to 8, characterised in that a control circuit (8) is connected to drive the first switch (S2) and the short-circuit switch (S3'; S5) (Fig. 5).

10. A process for the operation of a circuit arrangement as claimed in one of Claims 1 to 9, characterised in that the first switch (S2; 7) is not closed until the short-circuit switch (S5; 6) is opened.

11. A process for the operation of a circuit arrangement as claimed in one of Claims 5 to 9, characterised in that the first switch (S2; 7) and the short-circuit switch (S5; 6) are closed simultaneously in the phase of the initial charging and subsequent recharging.

12. A process for the operation as claimed in one of Claims 10 or 11, characterised in that the degree of the charging of the piezoelectric body (1'), and/or the capacitive element (C; 1'') is gauged by the duration of closure of the short-circuit switch (S5; 6).

13. A process for the operation as claimed in Claim 11 and 12, characterised in that when the charging voltage of the piezoelectric body (1') and/or of the capacitive element (C; 1'') has been reached the short-circuit switch (S5; 6) is opened.

14. Use of a circuit arrangement and operation thereof as claimed in one of Claims 1 to 13 for a piezoelectric control element having at least two piezoceramic bodies (10*, 10', 11'', 11, 12; $\overline{10}$, $\overline{11}$)

which are approximately equal in length, are arranged one beside another and each connected together at one of their adjacent ends by means of a cross-member ($\overline{19}$) and are electrically divided into two groups (10 and 11; 10, 10', 10'' and 11, 12), where all the piezoelectric bodies of the first group are operated in phase opposition to the piezoelectric bodies of the other group, where the piezoelectric bodies of the first group are connected as the capacitive element (C) and where the relative movement (20, $\overline{20}$) which results from the phase-opposing operation can be utilised between their adjacent other ends ($\overline{12}$, $\overline{4}$; 210, 211 to 212).

**Revendications**

1. Circuit pour un corps piézoélectrique devant être alternativement chargé et déchargé, par exemple un organe de réglage piézo-électrique, notamment pour la charge et la décharge en opposition de phase d'au moins deux corps piézo-électriques, caractérisé par le fait qu'aux bornes (3, 4) d'au moins un corps piézo-électrique (1') se trouve raccordé un circuit série formé d'un élément capacitif (C; 1''), notamment un second corps piézo-électrique (1'), une inductance (L) et un premier commutateur (S2; 7) pouvant être commandé, la capacité de cet élément (C; 1'') étant au moins approximativement égale à la capacité du corps piézo-électrique (1'') entre les bornes (3, 4), et l'inductance (L) étant dimensionnée de telle manière qu'elle peut réaliser magnétiquement un stockage temporaire de l'ensemble de l'énergie devant être transférée entre les bornes (3, 4) du corps piézo-électrique et de l'élément capacitif (C; 1''), et le premier commutateur (S2, 7) étant prévu pour interrompre le transport de charge du courant d'inversion de charge respectif, et qu'un circuit série formé d'une source d'énergie électrique (2; 5) servant à réaliser la première charge et la charge complémentaire du corps piézo-électrique ou de l'élément capacitif, et d'un second commutateur (S1; S4; 10) pouvant être commandé, est branché en parallèle avec les bornes (3, 4) du corps piézo-électrique ou en parallèle avec l'élément capacitif (C; 1''), et qu'un commutateur de court-circuit (S3; S3', S3''; S5, 6) pouvant être commandé est monté en parallèle avec lesdites bornes (3, 4) ou en parallèle avec l'élément capacitif (C; 1'').

2. Montage suivant la revendication 1, caractérisé par le fait que l'élément capacitif est un second corps piézo-électrique (1'') devant fonctionner en opposition de phase avec le corps piézo-électrique (1'').

3. Circuit suivant la revendication 1 ou 2, caractérisé par le fait que l'inductance (11'') possède une prise pour le raccordement du commutateur de court-circuit (S3'; S5; 6).

4. Circuit suivant la revendication 1 2 ou 3, caractérisé par le fait que la source de tension est une batterie (5).

5. Circuit suivant la revendication 4, caractérisé par le fait que la batterie (5), le second commutateur (S4; 10), le commutateur de court-circuit (S5; 6), l'inductance (L''') de la prise et l'inductance globale (L'') forment un transformateur de tension servant à la conversion de la tension électrique de la batterie (5) en la haute tension nécessaire (U$_H$) (figures 4 et 5).

6. Circuit suivant l'une des revendications 1 à 5, caractérisé par le fait que le premier commutateur (S2) est un triac (7) ou un circuit antiparallèle formé de thyristors.

7. Circuit suivant l'une des revendications 1 à 6, caractérisé par le fait que le second commutateur (S4) est une diode (10).

8. Circuit suivant l'une des revendications 1 à 7, caractérisé par le fait que le commutateur de court-circuit (S3'; S5) est un transistor (6) résistant à la tension.

9. Circuit suivant l'une des revendications 1 à 8, caractérisé par le fait qu'il est prévu un circuit de commande (8) qui, pour la commande du premier commutateur (S2) et du commutateur de court-circuit (S3', S5), est relié à ces derniers (figure 5).

10. Procédé de fonctionnement d'un circuit suivant l'une des revendications 1 à 9, caractérisé par le fait que le premier commutateur (S2; 7) n'est fermé que lorsque le commutateur de court-circuit (S5; 6) est ouvert.

11. Procédé de fonctionnement d'un circuit suivant l'une des revendications 5 à 9, caractérisé par le fait que le premier commutateur (S2; 7) et le commutateur de court-circuit (S5; 6) sont fermés simultanément pendant la phase de la première charge ou de la charge complémentaire.

12. Procédé de fonctionnement suivant l'une des revendications 10 ou 11, caractérisé par le fait que la valeur de la charge du corps piézo-électrique (1') et/ou de l'élement capacitif (C; 1'') est dimensionnée par la durée de fermeture du commutateur de court-circuit (S5; 6).

13. Procédé de fonctionnement suivant les revendications 11 et 12, caractérisé par le fait qu'une fois que la tension de charge du corps piézo-électrique (1') et/ou de l'élément capacitif (C; 1'') est atteinte, le commutateur de court-circuit (S5; 6) est fermé.

14. Application et fonctionnement d'un circuit suivant l'une des revendications 1 à 13 pour un organe de réglage piézo-électrique comportant au moins deux corps piézocéramiques approximativement de même longueur (10*, 10', 11'', 11, 12; $\overline{10}$, $\overline{11}$), qui sont disposés côte à côte et sont reliés entre eux, au niveau de l'une de leurs extrémités voisines, par une traverse ($\overline{19}$) et sont répartis électriquement en deux groupes (10 et 11; 10, 10', 10'' et 11, 12), tous les corps piézo-électriques d'un groupe fonctionnant en opposition de phase par rapport aux corps piézo-électriques de l'autre groupe, les corps piézo-électriques d'un groupe étant branchés de manière à constituer l'élément capacitif (C), tandis que le déplacement relatif (20, $\overline{20}$) obtenu sur la base du fonctionnement en opposition de phase, peut être obtenu entre les deux autres extrémités voisines ($\overline{12}$, $\overline{4}$; 210, 211 avec 212).

# FIG 1

# FIG 2

FIG 3

FIG 4

FIG 5

FIG 6

FIG 7a

FIG 7